Europäisches Patentamt

**European Patent Office**

Office européen des brevets

(19)

(11) Numéro de publication: **0 061 421**

**A1**

(12) # DEMANDE DE BREVET EUROPEEN

(21) Numéro de dépôt: **82810093.3**

(22) Date de dépôt: **04.03.82**

(51) Int. Cl.³: **H 03 B 5/36**

(30) Priorité: **24.03.81 FR 8106050**

(43) Date de publication de la demande:
**29.09.82 Bulletin 82/39**

(84) Etats contractants désignés:
**CH DE GB IT LI NL**

(71) Demandeur: **ASULAB S.A.**
**Faubourg du Lac 6**
**CH-2502 Bienne(CH)**

(72) Inventeur: **Leuenberger, Claude Eric**
**Grand Chézard**
**CH-2054 Chezard(CH)**

(74) Mandataire: **Barbeaux, Bernard et al,**
**ASUAG Département Brevets et Licences Faubourg du**
**Lac 6**
**CH-2501 Bienne(CH)**

(54) **Circuit intégré pour oscillateur à fréquence réglable.**

(57) Circuit intégré pour oscillateur à fréquence réglable utilisant des condensateurs à capacité variable intégrés.

Ce circuit est réalisé en technologie MOS. Chacun des condensateurs à capacité variable est consitué par une jonction $n^+$ $^-p$ située à l'interface (I1) d'une première zone (107) à type de conduction n+ et d'une seconde zone (108) à type de conduction p réalisées dans un substrat semi-conducteur de type n (131). Les première et seconde zones débouchent à la surface de la pastille de semi-conducteur. Un condensateur de découplage est associé au condensateur à capacité variable par la formation d'un empilement constitué par la partie (109a) de couche d'oxyde isolante recouvrant la partie de surface (110) de la pastille par où débouche ladite première zone (107) et par une couche électro-conductrice (111) recouvrant cette partie de couche isolante (109a).

Fig. 3

EP 0 061 421 A1

ESA 77

4-L/IR

## CIRCUIT INTEGRE POUR OSCILLATEUR A FREQUENCE REGLABLE

La présente invention concerne les circuits oscillateurs comprenant un résonateur tel qu'un cristal de quartz.

L'invention concerne, plus particulièrement, un circuit intégré destiné à l'établissement et l'entretien des oscillations d'un résonateur, ce circuit intégré étant muni de moyens pour ajuster la fréquence de ces oscillations. Ce circuit intégré est muni d'une première paire de bornes pour le branchement d'un résonateur, et d'une seconde paire de bornes pour le branchement d'une source d'alimentation électrique.

Afin de pouvoir régler à volonté la fréquence d'oscillation d'un circuit oscillateur du type PIERCE, c'est-à-dire du type comportant un condensateur d'entrée branché entre une borne d'entrée et un pôle de masse de la source d'alimentation électrique, et un condensateur de sortie branché entre ledit pôle de masse et une borne de sortie, on a déjà proposé d'utiliser comme condensateurs d'entrée et de sortie des condensateurs à capacité réglable réalisés en composants discrets qui sont connectés à des bornes convenables du circuit intégré.

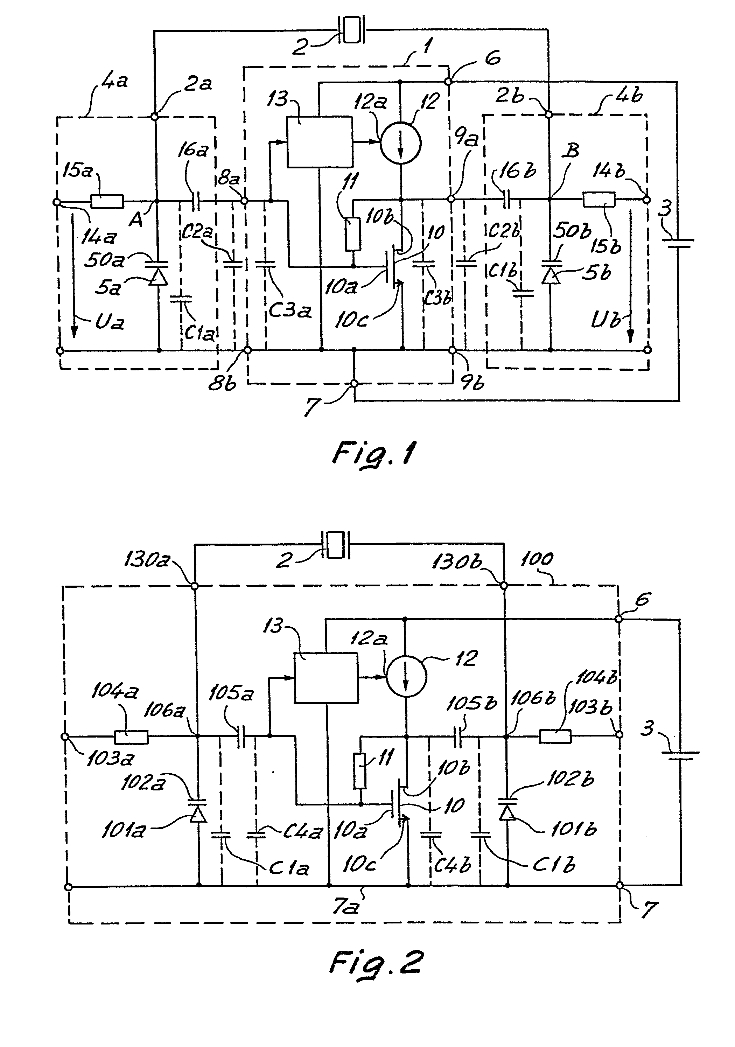

Sur la figure 1 annexée, on a représenté une application de cette solution connue à un oscillateur du type de celui qui est décrit dans le brevet suisse no 580358.

Le circuit représenté sur la figure 1 se compose d'un circuit intégré 1 réalisé en technologie CMOS, d'un résonateur à quartz 2, d'une source d'alimentation électrique continue 3, et de deux circuits 4a, 4b réalisés en composants discrets et comprenant chacun un condensateur 5a, 5b du type à capacité variable de façon continue en fonction de la tension qui lui est appliquée.

Le circuit intégré 1 comporte une paire de bornes 6,7 pour le branchement de la source d'alimentation 3, ainsi qu'une deuxième et une troisième paire de bornes 8a, 8b et 9a, 9b pour le branchement des circuits respectivement 4a et 4b.

Le circuit intégré 1 comporte un transistor MOS 10, par exemple à canal n, qui est polarisé par une résistance 11 branchée entre la grille 10a et le drain 10b de ce transistor 10 dont la source est désignée par 10c. Le courant circulant sur le trajet de courant commandé, ou trajet drain-source, du transistor 10 est déterminé par une source de courant 12, par exemple un transistor MOS à canal p, qui est branchée en série avec ledit trajet drain-source, entre les bornes d'alimentation 6 et 7 du circuit intégré 1. La source 12 est du type fournissant un courant réglable en fonction d'un signal de commande appliqué sur son entrée de commande 12a constituée, par exemple, par la grille dudit transistor à canal p. Ce signal de commande est fourni par un circuit régulateur 13 recevant le signal d'oscillation présent sur la grille 10a du transistor 10. Ce signal de commande est une fonction convenable de l'amplitude dudit signal d'oscillation, de telle sorte que le circuit 13 et la source de courant 12 constituent une boucle de régulation limitant l'amplitude dudit signal d'oscillation à une valeur faible, on trouvera dans le brevet suisse no 580 358 plusieurs exemples de réalisation du circuit régulateur 13.

Chacun des condensateurs 5a, 5b est branché entre, d'une part, la borne 8b respectivement 9b et, d'autre part, via un condensateur de découplage 16a, 16b, la borne 8a respectivement 9a du circuit intégré 1. Les bornes 8b et 9b sont reliées à l'une 7 des bornes d'alimentation. Une résistance d'adaptation respectivement 15a et 15b est interposée entre la borne de commande respectivement 14a et 14b, et l'armature 50a respectivement 50b opposée à la borne d'alimentation 7, du condensateur 5a respectivement 5b. Chaque armature 50a, 50b est également connectée à une borne respectivement 2a et 2b pour le branchement du quartz 2. Enfin, le condensateur de découplage respectivement 16a et 16b est interposé entre la borne 8a respectivement 9a et le point commun A respectivement B entre la résistance 15a respectivement 15b et le condensateur 5a respectivement 5b.

Il est ainsi possible de régler la valeur de la capacité de chacun des condensateurs 5a et 5b, par l'application, par rapport au potentiel de masse que constitue le potentiel de la borne 7, d'une tension de commande convenable Ua et Ub sur une borne de commande respectivement 14a et 14b des circuits respectivement 4a et 4b.

La demanderesse a constaté que le circuit représenté sur la figure 1 ne donne généralement pas satisfaction en raison de l'étroitesse de la plage des valeurs de fréquence auxquelles cet oscillateur peut être réglé, ainsi qu'en raison d'une consommation de courant relativement élevée. L'inconvénient mentionné ci-dessus en premier est principalement dû aux capacités parasites représentées sur la figure 1 sous les références C1a,C2a,C3a respectivement C1b,C2b,C3b, capacités parasites susceptibles de court-circuiter, en régime haute fréquence, le condensateur 5a respectivement 5b. Il a été constaté que, essentiellement les capacités parasites C1a et C2a respectivement C1b et C2b présentaient des valeurs relativement élevées; ceci est dû au fait que les circuits 4a et 4b sont réalisés en composants discrets.

Par ailleurs, le brevet allemand no 2.638.055 décrit un oscillateur à quartz comportant un circuit intégré connecté à un résonateur en cristal de quartz, ainsi qu'à une source d'alimentation électrique. Ce circuit, du type circuit de PIERCE à deux condensateurs, est conçu pour pouvoir établir et entretenir des oscillations du résonateur. De plus, ce circuit intégré comporte des moyens pour régler la fréquence d'oscillation du résonateur. Selon un exemple de réalisation décrit par la fig. 6 de ce brevet, ces moyens sont constitués par une pluralité de condensateurs de réglage du type connu dans la littérature sous le nom de "Bicap". On sait que de tels condensateurs peuvent prendre deux valeurs de capacité différentes selon que la tension qui leur est appliquée est inférieure ou supérieure à une valeur de seuil. Chacun de ces condensateurs est connecté, d'une part, aux éléments actifs du circuit et, d'autre part, à une borne de commande respective susceptible d'être reliée soit au pôle relié à la masse, soit à l'autre pôle, de la source d'alimentation électrique.

Ce circuit connu a notamment pour inconvénient de nécessiter un grand nombre de bornes de commande et un nombre correspondant de condensateurs de réglage, afin de permettre un réglage de la fréquence d'oscillation dans un domaine de fréquences suffisamment large et avec une résolution suffisamment faible, pour rendre possible l'utilisation de ce circuit dans le secteur des télécommunications. En outre, ce circuit connu nécessite un grand nombre d'organes de commutation pour commuter sur chaque borne de commande, soit l'un soit l'autre des pôles de la source d'alimentations électrique.

Il en résulte que ce circuit connu est lui-même de conception compliquée et donc coûteux et que son utilisation nécessite des moyens également compliqués et coûteux.

C'est pourquoi, l'un des buts de la présente invention est de proposer un nouveau circuit intégré pour l'établissement et l'entretien des oscillations d'un résonateur, ce circuit intégré devant être de conception et d'utilisation simples tout en permettant un réglage continu de la fréquence d'oscillation du résonateur dans un domaine de valeurs suffisamment large, par exemple avec un tirage $\Delta f/f$ de l'ordre de $\pm$ 200 ppm, ceci à des fréquences élevées, notamment de l'ordre de quelques MHz à 20 MHz, par exemple 16 MHz qui est une fréquence typiquement utilisée en télécommunication.

Selon la présente invention, la pluralité de condensateurs "Bicap" de l'art antérieur mentionné ci-dessus, est remplacée par au moins un condensateur du type à capacité variable de façon continue en fonction de la tension qui lui est appliquée, ce condensateur étant intégré dans la pastille formant le circuit d'entretien du résonateur. Une borne de sortie de commande du cicuit intégré est destinée à recevoir un signal de commande, par exemple signal de tension continue, permettant de déterminer la capacité de ce condensateur et donc, de régler la fréquence d'oscillation du circuit oscillateur formé par le branchement du résonateur et de la source d'alimentation électrique sur des bornes de sortie correspondantes du circuit intégré.

Ainsi, le circuit selon la présente invention est de conception simple puisqu'il ne nécessite, au minimum, qu'un condensateur à capacité variable et qu'une seule borne de commande, et qu'il permet un réglage continu de la fréquence d'oscillation du résonateur dans un large domaine de valeurs et avec une résolution qui n'est limitée que par celle avec laquelle le signal de commande est défini.

Selon un mode de réalisation actuellement préféré de l'invention, le circuit d'entretien intégré est réalisé en technologie MOS. Le condensateur à capacité variable est constitué par une jonction n+ -p située à l'interface d'une première zone de type de conduction n+ et d'une seconde zone de type de conduction p. La seconde zone est un caisson réalisée dans une pastille de semi-conducteur de type n et la première zone est une diffusion réalisée dans une région superficielle dudit caisson. La seconde zone est reliée à la borne destinée à être connectée au pôle négatif de la source d'alimentation électrique. Les première et seconde zones débouchent à la surface de la pastille de semi-conducteur. Un condensateur de découplage nécessaire au bon fonctionnement du circuit est formé par la partie de couche d'oxyde isolante recouvrant la partie de surface de la pastille par où débouche ladite première zone de conductivité n+, et par par une couche électro-conductrice recouvrant ladite partie de couche isolante.

Les caractéristiques et avantages de l'invention seront mieux compris à la lecture de la description qui va suivre de plusieurs modes de réalisation, description faite en référence aux dessins annexés dans lesquels :

- la figure 1, déjà décrite, représente un schéma électrique d'un oscillateur selon l'art antérieur utilisant des condensateurs à capacité variable en composants discrets;

- la figure 2 est un schéma électrique d'un circuit intégré d'établissement et d'entretien des oscillations d'un résonateur, selon un mode de réalisation de l'invention;

- la figure 3 est une coupe transversale à travers une pastille de circuit intégré réalisant un condensateur variable associé à un condensateur de découplage, selon un premier mode de réalisation;

- la figure 4 est une vue analogue à celle de la figure 3, montrant un second mode de réalisation de ladite association de condensateurs; et

- la figure 5 est une coupe transversale à travers une partie de circuit intégré formant une résistance utilisée dans le circuit de la figure 2.

Sur la figure 2, les éléments identiques ou analogues à ceux de la figure 1 portent les mêmes références. La figure 2 représente une pastille de circuit intégré 100 qui comporte, comme la pastille 1 représentée sur la figure 1, une paire de bornes de sortie 6,7 pour le branchement d'une source d'alimentation électrique continue 3, ainsi que des éléments de circuit 10 à 13 dont le fonctionnement est analogue à celui des éléments portant la même référence décrits en relation avec la figure 1.

Le circuit intégré 100 comporte, en outre, deux condensateurs 101a, 101b à capacité variable de façon continue en fonction de la tension qui leur est appliquée, ces condensateurs étant, chacun branchés entre la borne d'alimentation reliée à la masse 7 et l'une 130a respectivement 130b de deux bornes de sortie du circuit 100, entre lesquelles est branché le résonateur à quartz 2. L'armature 102a respectivement 102b des condensateurs 101a respectivement 101b, armature située à l'opposé de la borne d'alimentation 7, est reliée à une borne de sortie de commande 103a respectivement 103b du circuit intégré 100, via une résistance 104a respectivement 104b également intégrée dans le circuit 100.

Un condensateur de découplage 105a respectivement 105b est interposé entre, d'une part, le point de jonction 106a respectivement 106b entre la résistance 104a et le condensateur 101a respectivement la résistance 104b et le condensateur 101b, et, d'autre part, la grille 10a du transistor 10 respectivement le drain 10b de ce transistor 10.

Pour faciliter la comparaison entre les figures 1 et 2, on a désigné sur la figure 2 par C1a et C1b la capacité parasite présente entre les bornes du condensateur 101a respectivement 101b, et par C4a et C4b la capacité parasite existant entre le conducteur commun 7a relié à la borne d'alimentation 7, et l'armature adjacente au transistor 10 du condensateur de découplage 105a respectivement 105b. Il va de soi que les capacités parasites C4a et C4b sont chacune équivalente au montage formé par les capacités parasites C2a et C3a respectivement C2b et C3b branchées en parallèle.

La demanderesse a constaté que le remplacement des condensateurs 5a et 5b de la figure 1 par les condensateurs 101a et 101b intégrés dans le circuit d'entretien 100, permettait de tirer le maximum de profit de l'étendue de la plage de variation de la capacité de ces condensateurs 101a, 101b et d'obtenir un tirage $\Delta f/f$ de l'ordre de $\pm 100$ ppm pouvant aller jusqu'à $\pm 250$ ppm, à des fréquences comprises entre 10 et 20 MHz. Ce résultat surprenant peut être expliqué en partie par le fait que les capacités parasites C1a et C4a respectivement C1b et C4b sont considérablement diminuées grâce à l'intégration des condensateurs 101a et 101b dans le circuit 100.

De plus, l'intégration des condensateurs à capacité variable permet de réduire notablement l'encombrement du circuit oscillateur complet ainsi que la consommation de courant électrique de ce circuit.

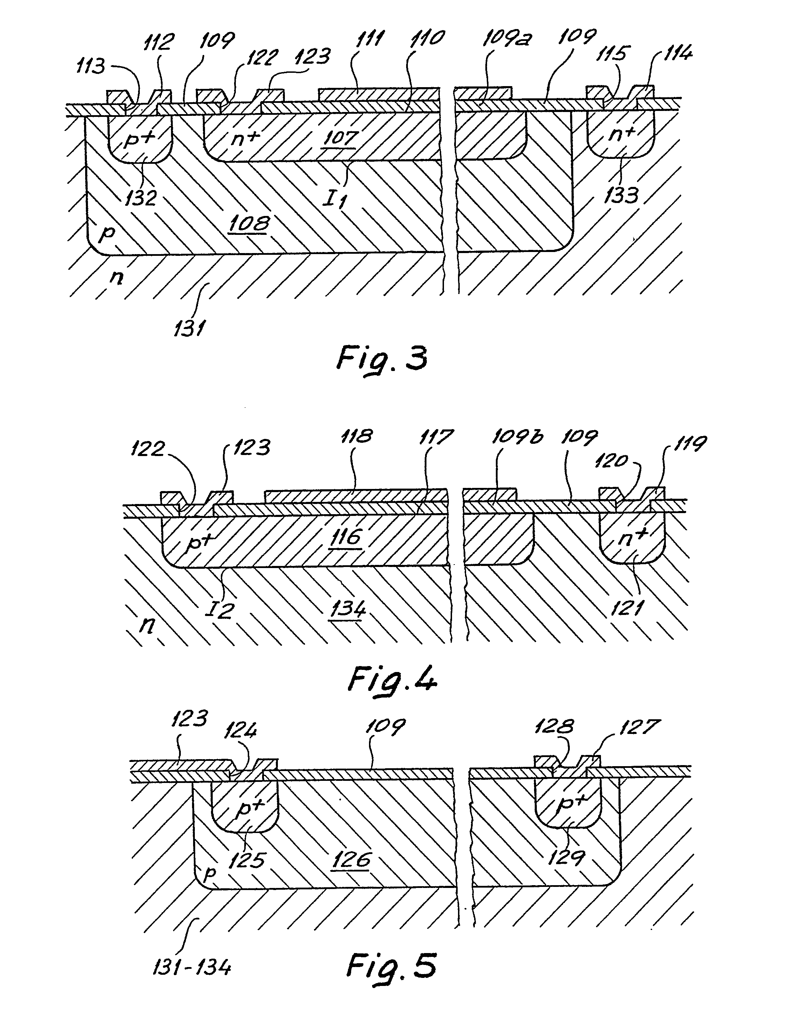

On décrit maintenant en référence aux figures 3 et 4, deux modes de réalisation en technologie MOS d'un condensateur variable tel que le condensateur 101a ou 101b, associé à un condensateur de découplage tel que le condensateur 105a respectivement 105b, le mode de réalisation de la figure 3 étant directement applicable au circuit 100 de la figure 2.

Selon le mode de réalisation représenté sur la figure 3, chaque condensateur 101a respectivement 101b du circuit de la figure 2 est constitué par une jonction n+ -p obtenue à l'interface I1 entre une diffusion 107 de type n+ et un caisson 108 de type p, réalisés dans un substrat de type n, 131 d'une pastille en silicium semi-conducteur. Une couche de silice 109 recouvre la surface supérieure de la pastille.

Le condensateur de découplage 105a respectivement 105b associé au condensateur à capacité variable 101a respectivement 101b, est formé par la partie de couche de silice 109a recouvrant la zone de surface 110 par laquelle débouche la diffusion 107. Une couche électro-conductrice 111, par exemple une couche d'aluminium ou une couche de silicium polycristallin fortement dopé, constitue une armature du condensateur de découplage 105a respectivement 105b, dont l'autre armature est constituée par la diffusion n+, 107 elle-même.

La borne d'alimentation 7 peut être constituée par une couche électro-conductrice 112 recouvrant une fenêtre 113 ménagée dans la couche de silice 109 au droit d'une diffusion de type p+, 132 réalisée dans le caisson 108. L'autre borne d'alimentation 6 peut être constituée par le dépôt d'une couche conductrice 114 recouvrant une fenêtre 115 ménagée dans la couche de silice 109 au droit d'une diffusion de type n+, 133 réalisée dans le substrat de type n, 131 de la pastille semi-conductrice formant le circuit intégré 100.

Selon le mode de réalisation représenté sur la figure 4, un condensateur à capacité variable est réalisé par une jonction n- p établie à l'interface I2 entre une diffusion de type p+, 116 et un substrat semi-conducteur de type n, 134. Le condensateur de découplage associé au condensateur I2 est réalisé, comme dans le cas de la figure 3, par la partie de couche isolante 109b recouvrant la zone de surface 117 par laquelle débouche la diffusion 116. Une couche électro-conductrice 118 recouvrant ladite partie 109b constitue une armature du condensateur de découplage dont l'autre armature est consituée par la diffusion p+, 116 elle-même.

Une borne d'alimentation reliée directement à une armature du condensateur (I2) peut être constituée par une couche conductrice 119 recouvrant une fenêtre 120 ménagée dans la couche de silice 109 au droit d'une diffusion de type n+, 121 qui est réalisée dans le substrat de type n, 134. Cependant, pour que la jonction n- p+ entre les zones 134 et 116 soit polarisée correctement, il est nécessaire de relier la borne d'alimentation 119 au pôle positif de la source d'alimentation électrique 3 contrairement à ce qui est représenté sur la figure 2.

En conséquence, si l'on réalise les condensateurs à capacité variable 101a, 101b conformément au mode de réalisation de la figure 3, il convient de modifier légèrement le schéma du circuit 100 de la figure 2 en inversant la polarité de la source 3 et en utilisant un transistor et une source de courant de types convenables à la place du transistor 10 et de la source 12, respectivement.

Dans le cas de la figure 3 comme dans celui de la figure 4, la couche conductrice 111 respectivement 118 formant une armature du condensateur de découplage, s'étend de préférence sur presque la totalité de l'étendue de la jonction I1 respectivement I2. On a constaté en effet que cela permettait de réduire au minimum la valeur de la capacité parasite apparaissant aux bornes du condensateur à capacité variable I1 respectivement I2.

Il est cependant utile de laisser libre une petite portion marginale de la partie de couche isolante 109a respectivement 109b afin d'y ménager une fenêtre 122 recouverte par une couche électro-conductrice 123 pour réaliser une prise de contact constituant le point de jonction, tel que le point 106a ou 106b du circuit 100, entre le condensateur de découplage et le condensateur à capacité variable (figures 3 et 4).

La figure 5 montre un exemple de réalisation d'une résistance intégrée dont une des bornes est reliée au point de jonction entre les condensateurs (I1) et (107, 109a, 111) respectivement (I2) et (116, 109b, 118).

Selon cet exemple de réalisation, la couche électro-conductrice 123 se prolonge jusqu'au droit d'une autre fenêtre 124 ménagée dans la couche de silice 109 au droit d'une diffusion p+, 125 située à une extrémité d'un caisson de type p, 126 réalisé dans dans le substrat de type n, 131 ou 134. Ce caisson constitue la résistance telle que celle qui est référencée 104a ou 104b sur la figure 2. L'une des bornes de cette résistance est la couche 123 qui recouvre la fenêtre 124; l'autre borne de cette résistance est constituée par une couche électro-conductrice 127 recouvrant une fenêtre 128 de la couche de silice 109; la fenêtre 128 est située au droit d'une diffusion p+ 129 se trouvant à l'extrémité du caisson 126 opposée à la diffusion 125.

La couche 127 constitue une borne de sortie du circuit intégré, telle que la borne 103a ou 103b du circuit intégré de la figure 2.

Bien entendu, les résistances intégrées 104a, 104b du circuit 100 de la figure 2 peuvent être réalisées selon une autre technologie; par exemple ces résistances peuvent être formées par un réseau de diodes constituées dans une couche de silicium polycristallin formant les couches électroconductrices du circuit intégré. Alternativement, les résistances 104a, 104b peuvent être formée chacune par un transistor MOS convenablement polarisé.

Par ailleurs, l'un des condensateurs 101a ou 101b du circuit 100 peut être à capacité fixe. Dans ce cas, le condensateur de découplage (105a respectivement 105b), la résistance (104a respectivement 104b) et la borne de commande (103a respectivement 103b) associés audit condensateur fixe peuvent être supprimés.

La présente invention est notamment applicable aux oscillateurs commandés par un signal de tension utilisés dans les dispositifs de télécommunication à modulation de fréquence.

Cette invention est aussi utilisable dans les montres électroniques ou les dispositifs de télécommunication utilisant un oscillateur dont la fréquence doit être corrigée en fonction de la température du résonateur de cet oscillateur. Dans le cas, ce signal de commande appliqué sur les bornes de commande du circuit intégré, est fourni par un thermomètre à sortie d'information électrique.

REVENDICATIONS

1. Circuit d'établissement et d'entretien des oscillations d'un résonateur (2), du type comportant, intégrés dans une même pastille de semi-conducteur (100), une première paire de bornes (130a, 130b) pour le branchement du résonateur (2); une deuxième paire de bornes (6,7) pour le branchement d'une source d'alimentation électrique (3); au moins un élément actif amplificateur (10) et des moyens pour régler la fréquence desdits oscillations, ces moyens comprenant au moins une borne de sortie de commande ($103_a$,103b) de ladite pastille de semi-conducteur (100) et au moins un condensateur de réglage (101a,101b) dont la capacité détermine la fréquence desdites oscillations, ce condensateur étant relié à ladite borne de sortie de commande, et étant agencé pour que la tension électrique entre ses bornes soit déterminée en fonction d'un signal de commande appliqué sur ladite borne de commande, caractérisé en ce que ledit condensateur de réglage (101a, 101b) est du type à capacité variable de façon continue en fonction de la tension qui lui est appliquée.

2. Circuit selon la revendication 1, caractérisé en ce que le condensateur de réglage (101a,101b) comprend une jonction (I1;I2) entre deux zones de types de conductivité opposés (108 resp. 107;134 resp. 116) de la pastille de semi-conducteur (100).

3. Circuit selon l'une quelconque des revendications 1 et 2, caractérisé en ce qu'un condensateur de découplage (105a, 105b) intégré dans la pastille de semi-conducteur (100) est interposé dans la liaison entre ledit condensateur de réglage (101a, 101b) et ledit élément actif (10).

4. Circuit selon l'une quelconque des revendications 1 à 3, caractérisé en ce qu'une résistance (104a, 104b) intégrée dans la pastille de semi-conducteur (100) est interposée dans la liaison entre ledit condensateur de réglage (101a, 101b) et la borne de sortie de commande (103a, 103b) à laquelle est relié ce condensateur.

5. Circuit selon les revendications 2 et 3 prises en combinaison, caractérisé en ce que ledit condensateur de découplage (105a, 105b) comprend une couche isolante (109a;109b) recouvrant l'une (107;116) desdites zones de types de conductivité opposés, cette couche isolante étant revêtue d'une couche électro-conductrice (111;118).

6. Circuit selon l'une quelconque des revendications 3 et 5, caractérisé en ce que ledit condensateur de découplage, (105a,105b) recouvre sensiblement la totalité de ladite jonction (I1;I2) constituant le condensateur de réglage (101a, 101b).

7. Circuit selon l'une quelconque des revendications 5 et 6, caractérisé en ce qu'il est réalisé en technologie MOS avec une couche d'oxyde isolante (109), et en ce que ladite couche isolante formant le condensateur de découplage comprend une partie (109a;109b) de ladite couche d'oxyde.

8. Circuit selon la revendication 2, caractérisé en ce que ladite jonction (I1) est l'interface entre deux zones (108 resp. 107) de type respectivement p et n+ de la pastille de semi-conducteur (100).

9. Circuit selon la revendication 2, caractérisé en ce que ladite jonction (I2) est l'interface entre deux zones (134 resp. 116) de type respectivement n et p+ de la pastille de semi-conducteur (100).

10. Circuit selon l'une quelconque des revendications 2 à 9, caractérisé en ce que l'une desdites zones de types de conductivité opposés est une diffusion (107;116) réalisée dans une zone superficielle de la pastille de semi-conducteur (100).

Fig.1

Fig.2

0061421

1/2

Fig. 3

Fig. 4

Fig. 5

Office européen
des brevets

RAPPORT DE RECHERCHE EUROPEENNE

**0061421**

Numéro de la demande

EP 82 81 0093

## DOCUMENTS CONSIDERES COMME PERTINENTS

| Categorie | Citation du document avec indication en cas de besoin des parties pertinentes | Revendication concernee | CLASSEMENT DE LA DEMANDE (Int Cl ³) |
|---|---|---|---|
| Y | FR - A - 2 399 738 (PHILIPS) <br><br> * page 1, ligne 1 - page 7, ligne 34; figures 1-5 * <br><br> -- | 1-3, 5-10 | H 03 B 5/36 |
| Y | US - A - 3 868 597 (GOLLINGER) <br><br> * colonne 2, ligne 11 - colonne 4, ligne 23 * <br><br> -- | 1,3 | |
| A | US - A - 4 141 209 (BARNETT et al) <br><br> * colonne 2, lignes 21-52; figures 1-3 * <br><br> -- | 1,3,4 | |
| D,A | DE - A - 2 638 055 (EBAUCHES) <br><br> * page 1, ligne 1 - page 7, ligne 26; figures 3-6 * <br><br> & CH - A - 609 525 <br><br> -- | 1 | DOMAINES TECHNIQUES RECHERCHES (Int Cl ³) <br><br> H 03 B <br> H 03 C <br> H 03 K <br> G 04 F |
| A | RADIO MENTOR ELECTRONIC, vol.37, no.7, juin 1971 MUNICH (DE) H. KELLER: "Integrierte Schaltungen für electronische Uhren" pages 420-426 <br><br> * page 420, colonne de droite, lignes 9-46; figure 2 * <br> ./.. | 1-10 | |

Le present rapport de recherche a ete etabli pour toutes les revendications

| Lieu de la recherche | Date d'achevement de la recherche | Examinateur |
|---|---|---|
| La Haye | 29 juin 1982 | DHONDT |

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée |
|---|---|---|
| A | JOURNAL SUISSE D'HORLOGERIE, no.11/12, décembre 1971 LAUSANNE (CH) H. KELLER et al.: "SAJ 220 - Une conception nouvelle de circuit intégré pour montres bracelet à quartz" pages 315-319 | |
| | * page 316, colonne de gauche, lignes 20-46; figure 7 * | 1 |
| | -- | |
| D,A | CH - A - 580 358 (CENTRE ELECTRONIQUE HORLOGER) | |
| | * colonne 2, ligne 36 - colonne 6, ligne 55; figures 1-8 * | 1 |
| | ----- | |

CLASSEMENT DE LA DEMANDE (Int. Cl.³)

DOMAINES TECHNIQUES RECHERCHES (Int. Cl.³)

OEB Form 1503.2  06.78